# EUROPEAN PATENT APPLICATION

(11) **EP 3 730 667 A2**
(43) Date of publication of application: **28.10.2020**
(21) Application number: 20170935.9
(22) Date of filing: 22.04.2020
(51) Int. Cl.: C23C 14/00, C23C 4/10, C23C 14/08, C23C 14/30, C23C 14/54, C23C 28/00, C23C 14/50, C23C 4/129, C23C 4/134, C23C 28/04, C04B 35/488

(54) **A PROCESS FOR LIMITING A CRITICAL STABILIZER CONTENT IN COATINGS, A COATING DEPOSITION SYSTEM, THERMAL BARRIER COATING WITH REDUCED STABILIZER CONTENT**

(30) Priority: 23.04.2019 US 201916392003
(71) Applicant: Raytheon Technologies Corporation, Farmington, CT 06032 (US)
(72) Inventor: WESSELS, Kaylan M, West Hartford, CT Connecticut 06119 (US); HAZEL, Brian T, Avon, CT Connecticut 06001 (US); MALONEY, Michael J, Marlborough, CT Connecticut 06447 (US); LITTON, David A, West Hartford, CT Connecticut 06107 (US); ZALESKI, Elisa M, Manchester, CT Connecticut 06040 (US)
(74) Representative: Dehns

(57) **Abstract**

In accordance with the present disclosure, there is provided a process for limiting a critical stabilizer content in coatings comprising placing a source coating material (34) in a crucible (32) of a vapor deposition apparatus (10) having a coating chamber (14), the source coating material (34) having compositional range of LnO_{1.5} comprising a single cation mol% of 30-50% relative to zirconia (ZrO₂), where Ln = La, Pr, Nd, Sm, Eu, Gd, and Tb and combinations thereof; energizing the source coating material (34) with an electron beam that delivers a power density to the material in the crucible (32) forming a vapor cloud from the source coating material (34); and depositing the source coating material (34) as a coating system onto a surface of a work piece (12).

## Description

### BACKGROUND

The present disclosure is directed to an improved coating process, and more particularly the control of a source material for a stabilized zirconia thermal barrier coating in order to minimize the risk of a local compositional of the coating exceeding a critical stabilizer content.

Gas turbine engines are well developed mechanisms for converting chemical potential energy, in the form of fuel, to thermal energy and then to mechanical energy for use in propelling aircraft, generating electric power, pumping fluids, etc. At this time, the major available avenue for improved efficiency of gas turbine engines appears to be the use of higher operating temperatures. However, the metallic materials used in gas turbine engines are currently very near the upper limits of their thermal stability. In the hottest portion of modern gas turbine engines, metallic materials are used at gas temperatures above their melting points. They survive because they are air cooled, but providing air cooling reduces engine efficiency.

Accordingly, there has been extensive development of thermal barrier coatings for use with cooled gas turbine aircraft hardware. By using a thermal barrier coating, the amount of cooling air required can be substantially reduced, thus providing a corresponding increase in efficiency.

Thermal barrier coatings have been deposited by several techniques including thermal spraying (plasma, flame and HVOF), sputtering, and electron beam physical vapor deposition (EB-PVD). Of these techniques, electron beam physical vapor deposition is currently a preferred technique for demanding applications because it produces a unique coating structure. Electron beam physical vapor deposited ceramic materials, when applied according to certain parameters, have a columnar grain microstructure consisting of small columns separated by gaps which extend into the coating. These gaps allow substantial substrate expansion without coating cracking and/or spalling.

Despite the success with the current use of electron beam physical vapor deposited zirconia base coatings, there is a continuing desire for improved coatings which exhibit superior thermal insulation capabilities, especially those improved in insulation capabilities when normalized for coating density.

An exemplary coating mixture includes a combination of gadolinia (Gd₂O₃) and zirconia (ZrO₂). The target composition of this mixture comprises 50 mol% GdO_{1.5} and 50 mol% ZrO₂ in single cation mol%, which corresponds to the pyrochlore compound Gd₂Zr₂O₇ as can be found in U.S. patent 6,117,560.

These two species have mismatched vapor pressures, leading to fluctuations around the target composition when deposition instabilities occur. Deposition instabilities may include pressure changes, electron beam changes or disruptions, power density changes in the evaporating pool, inconsistencies in the raw material, and the like. As a result, layers of the coating can be deposited that are off the target stoichiometry. When the fluctuation of a given layer exceeds a critical GdO_{1.5} content, the thermodynamically stable phase assemblage consists of the target pyrochlore phase and a gadolinia-rich phase. This phase assemblage is susceptible to attack by gaseous sulfur during engine service. In certain conditions the sulfur attack is in the form of a combination with sulfur available from the gas path. What is needed is to reduce the GdO_{1.5} content in the source material relative to ZrO₂, such that the mean and range of the final coating composition are shifted, reducing the risk of attack.

Similar reactions with gaseous sulfur during engine service are expected for certain other zirconia stabilizers that form the pyrochlore phase at the 50 mole% LnO_{1.5}, 50 mole% ZrO₂ compositions, where Ln =La, Pr, Nd, Sm, Eu and Tb. Therefore, similar reductions in LnO_{1.5} content in the source material relative to ZrO₂ are needed to avoid this attack in engine service for these stabilizers.

The critical LnO_{1.5} content (where Ln = La, Pr, Nd, Sm, and Eu) varies with the Ln metal. The range of LnO_{1.5} compositions over which the single pyrochlore phase is thermodynamically stable gets progressively narrower going from Tb to Gd, Gd to Eu, to Sm, to Nd, to Pr, and to La, according to published experimental phase diagrams. Thus the critical content of LnO_{1.5} above which two phases become stable goes down in that same order.

### SUMMARY

In accordance with the present disclosure, there is provided a process for limiting a critical stabilizer content in coatings comprising placing a source coating material in a crucible of a vapor deposition apparatus having a coating chamber, the source coating material having compositional range of LnO_{1.5} comprising a single cation mol% of 30-50% relative to zirconia (ZrO₂), where Ln = La, Pr, Nd, Sm, Eu, Gd, and Tb and combinations thereof; energizing the source coating material with an electron beam that delivers a power density to the material in the crucible forming a vapor cloud from the source coating material; and depositing the source coating material as a coating system onto a surface of a work piece.

In an optional embodiment, the process further comprises depositing at least one layer of the coating system comprising phases of the source material having a mixture of pyrochlore and zirconia-rich fluorite.

In an optional embodiment, the process further comprises minimizing the probability of the coating system exceeding a critical stabilizer content.

In an optional embodiment, the critical GdO_{1.5} content comprises an amount of 57 mol% or greater.

In an optional embodiment, the process further comprises preventing formation of a local compositional zone within the coating system between an inner layer and an outer layer of a thermal barrier coating of the coating system or within the outer layer, of a thermal barrier coating of the coating system.

In an optional embodiment, wherein the local compositional zone comprises a gadolinia content in a band that exposes the coating system to attack by sulfur and the formation of a gadolinium-containing sulfate phase.

In accordance with the present disclosure, there is provided a coating deposition system comprising a source material, the source material having compositional range of a stabilizer comprising a single cation mol% range of 30-50 mol% relative to zirconia or hafnia; an energy source configured to energize the source material; a work piece targeted by the deposition system; wherein the thermal source (or energy source) energizes the source material to form a coating system on the work piece.

In an optional embodiment, wherein the coating (system) comprises layers of a thermal barrier coating.

In an optional embodiment, the coating deposition system is configured to prevent formation of a local compositional zone within the layers of the thermal barrier coating.

In an optional embodiment, the coating deposition system is configured to minimize the probability of the coating (system) exceeding a critical stabilizer content.

In an optional embodiment, the critical stabilizer content comprises an amount of 57 mol% or greater.

In an optional embodiment, wherein said source material comprises oxides in the form of Ln₂B₂O₇, where Ln is selected from the group consisting of La, Pr, Nd, Sm, Eu, Gd, and Tb; wherein B is selected from the group consisting of Zr and Hf.

In accordance with the present disclosure, there is provided a spallation resistant thermal barrier coating formed by a process comprising providing a source material having compositional range configured to shift a mean distribution of compositional fluctuations in the thermal barrier coating resulting from the source material; depositing the source coating material onto a work piece; and forming a coating system comprising a thermal barrier coating.

In an optional embodiment the process further comprises placing the source material in a crucible of a vapor deposition apparatus having a coating chamber, the source material having a compositional range in single cation mol% of 30-50%; energizing the source material with an electron beam that delivers a power density to the material in the crucible forming a vapor cloud from the source coating material.

In an optional embodiment, the process further comprises forming a bond coat on a surface of the work piece.

In an optional embodiment, the coating system further comprises an oxide layer on top of the bond coat opposite the surface of the work piece.

In an optional embodiment, the thermal barrier coating further comprises an inner layer on the oxide layer and an outer layer on the inner layer opposite the oxide layer in the absence of a local compositional zone in said thermal barrier coating.

In an optional embodiment, the local compositional zone comprises a GdO_{1.5} content of 57 mol% or greater in a band within the coating system.

In an optional embodiment, the local compositional zone comprises a gadolinia content in a band that exposes the coating system to attack by sulfur and the formation of a gadolinium-containing sulfate phase.

In an optional embodiment, the process further comprises controlling stabilizers in the source material, the stabilizers selected from the group consisting of La, Pr, Nd, Sm, Eu, Gd, and Tb.

In an optional embodiment, the process further comprises placing the source material comprising particles in a source container coupled to a thermal spray torch, the source material having a compositional range in single cation mol% of 30-50%; propelling the source material particles into the thermal spray torch; heating the source material particles within a flame of the thermal spray torch; and forming multiple splats on the work piece, wherein the multiple splats include a compositional fluctuation below a threshold for stabilizer content of 57 single cation mol%.

Other details of the process are set forth in the following detailed description and the accompanying drawings wherein like reference numerals depict like elements.

### BRIEF DESCRIPTION OF THE DRAWINGS

FIG. 1 illustrates an exemplary electron beam vapor deposition apparatus.
FIG. 2 is a schematic illustration of an exemplary thermal barrier coating.
FIG. 3 is an exemplary graph of various gadolinia contents in a gadolinium zirconate layer of an exemplary coating.

### DETAILED DESCRIPTION

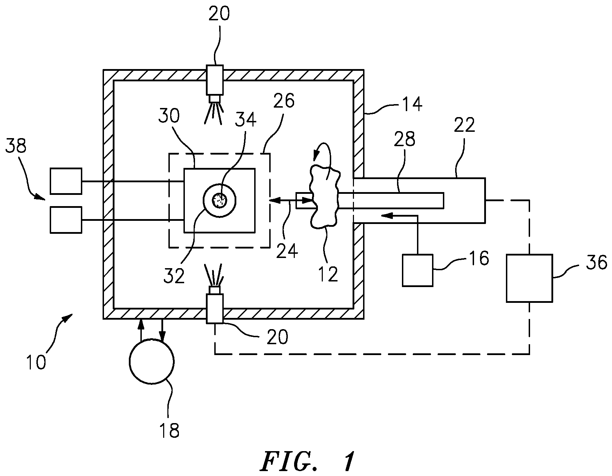

Figure 1 illustrates an example electron beam vapor deposition apparatus 10 (hereafter "the deposition apparatus 10") for coating a work piece 12 (or work pieces 12), such as airfoils, blades, vanes, combustion hardware, and blade outer air seals or paired turbine vanes of a gas turbine engine.

Additionally, the type of coating deposited onto the work piece 12 may be any coating that is suitable for vapor deposition. For example, the coating may be a ceramic thermal barrier coating that includes gadolinia, zirconia, yttria, or combinations thereof.

The deposition apparatus 10 includes a coating chamber 14 for containing the work pieces 12 during a coating operation and establishing desirable coating conditions. For instance, the coating chamber 14 may be a vacuum chamber and may include various ports for evacuating the interior or for selectively introducing process gases. A gas source 16 may provide a desired flow of oxygen or other process gas into the coating chamber 14. Optionally, a pump 18 may circulate a coolant (e.g., water) through walls of the coating chamber 14 to control wall temperature.

At least one electron beam source 20, such as an electron gun, is mounted relative to the coating chamber 14 for melting and evaporating a source coating material 34, such as an ingot. In the disclosed example, two electron beam sources 20 are shown; however, the deposition apparatus 10 may alternatively include a single electron beam source 20 or more than two electron beam sources 20. Given this description, one of ordinary skill in the art will recognize an appropriate number of electron beam sources 20 to meet their particular needs. In an exemplary embodiment, there can be multiple source coating materials 34.

A transport 22 is configured to hold and move the work piece 12 back and forth in direction 24, including rotation, tilt/pitch, and other degrees of motion to move the work piece 12 in and out of the coating chamber 14 and in and out of a coating zone 26 where the work piece 12 is to be coated. For instance, the coating zone 26 may be the spatial volume in the coating chamber 14 where the work piece 12 is coated. In this example, the transport 22 includes a shaft 28 that may be adapted to receive one or more fixtures that hold one or more of the work pieces 12. The shaft 28 may be translated in a known manner using a motor, actuator, or the like.

A coating device 30 is located near the coating zone 26, such as below the coating zone 26, and includes at least one crucible 32 for presenting at least one source coating material 34 that is to be deposited onto the work piece 12. For instance, the coating device 30 may include a single crucible that is used for the deposition apparatus 10. A desirable stand-off distance may be established between the coating device 30 and the coating zone 26 and/or work piece 12, depending on the geometry of the work piece 12, settings of the electron beam source(s) 20, and other factors.

Optionally, the deposition apparatus 10 may also include a thermal hood (not shown) arranged near the coating zone 26 to facilitate temperature control. As an example, one thermal hood is disclosed in application co-pending and commonly-owned Ser. No. 12/196,368 entitled "DEPOSITION APPARATUS HAVING THERMAL HOOD".

A controller 36 is in communication with the transport 22 and, optionally, the electron beam source 20 and possibly other components of the deposition apparatus 10 to control the operation thereof. The controller 36 may include software, hardware, or both for operating the deposition apparatus 10. The controller 36 may be configured to control movement of the work piece 12 in and out of the coating chamber 14 into the coating zone 26 and movement of the work piece 12 within the coating zone 26 during a coating operation. A deposition gas source(s) 38 is coupled to the crucible 32 and provides deposition gas.

The controller 36 can also control the feed rate of the ingot of deposition material being fed into the crucible 32.

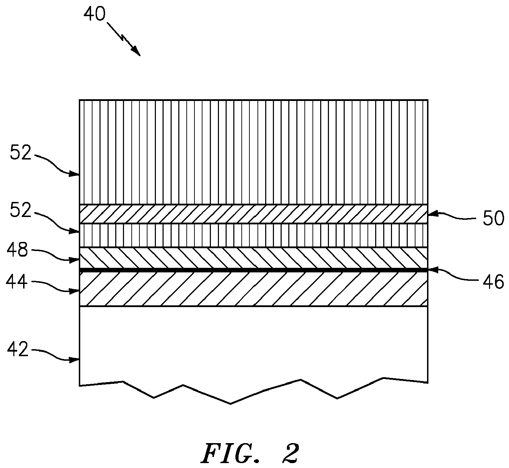

With reference to Fig. 2, an exemplary coating system 40 is shown. The coating system 40 is applied to a substrate 42 of the work piece 12. The substrate 42 can be a metal alloy, such as a nickel based alloy. A bond coat layer 44 can be deposited on the substrate 42. The bond coat 44 can comprise a metallic material. The bond coat 44 may include any suitable type of bonding material for attaching the coating system 40 to the substrate 42. In some embodiments, the bond coat 44 includes a nickel alloy, platinum, or MCrAlY where the M includes at least one of nickel, cobalt, iron, or combination thereof, Cr is chromium, Al is aluminum and Y is yttrium. The bond coat layer 44 may be approximately 0.005 inches thick (approximately 0.127 millimeters), but may be thicker or thinner depending, for example, on the type of material selected and requirements of a particular application.

An oxide layer 46 can be formed on top of the bond coat 44 opposite the substrate 42. The oxide layer 46 can be a thermally grown oxide layer 46. An optional first thermal barrier coating layer 48 or simply inner layer 48 of the thermal barrier coating is formed on the oxide layer 46. It is contemplated that in alternative embodiments, a single layer 48, two layer or multiple layers in the coating can be utilized. During certain process conditions, a local compositional zone 50 can form within thermal barrier coating system 40. In this exemplary embodiment, the local compositional zone 50 has formed within an outer layer 52 of the thermal barrier coating 40.

Within the local compositional zone 50 the content of stabilizer such as gadolinia, is sufficient to make that zone 50 susceptible to sulfur attack; the evolution and weakening of the coating microstructure in this local compositional zone 50 as a result of this attack causes the coating system 40 to become susceptible to spallation. The thermal barrier coating 48, 52 may be any type of ceramic material suited for providing a desired heat resistance in the gas turbine article. At least one layer (usually outer layer) can be of a targeted cubic, pyrochlore, or other similarly high rare earth stabilized composition. Specific examples are those of pyrochlore Ln₂B₂O₇ where Ln = La, Pr, Nd, Sm, Eu, Gd, Tb, or combinations and B = Zr, Hf, or combinations.

The thermal barrier coating 48, 52 may be any type of ceramic material suited for providing a desired heat resistance in the gas turbine article. At least one layer (usually outer layer) can be of a targeted cubic or pyrochlore. Specific examples are those of pyrochlore Ln₂B₂O₇ phase where Ln = La, Pr, Nd, Sm, Eu, Gd, Tb or combinations and B = Zr, Hf, or combinations.

In an exemplary embodiment, the coating system 40 can be any variety of coating, including but not limited to abradable coating, thermal barrier coating and the like.

Optional first layer 48 may be of an alternate material that may or may not be susceptible to similar sulfur attack, for example 7wt% yttria stabilized zirconia.

The disclosed process contemplates the control of the source material 34, (such as, ingot, particles in suspension, particles in powders and the like) such that during coating, the local compositional zone 50 is prevented or reduced. The exemplary process includes controlling the stabilizer content in the source material 34 relative to ZrO₂. By controlling the stabilizer content in the source material 34 relative to ZrO₂ the mean and range of the final coating composition are shifted, reducing the risk of attack of the coating system 40 by sulfur.

In alternative coating systems 40 the process can include controlling stabilizers including La, Pr, Nd, Sm, Eu, Gd and Tb.

In an exemplary embodiment, the process includes an EB-PVD source material 34 for a stabilized zirconia or hafnia thermal barrier coating 40. In the exemplary embodiment, the source material 34 composition stabilizer is gadolinium oxide (GdO_{1.5}) comprising an average of 40-50 in single cation mol% (50-59 wt%) relative to zirconia (ZrO2) and the resulting thermodynamically stable phases of the material are a mixture of pyrochlore and zirconia-rich fluorite. In another exemplary embodiment, the stabilizer average can be broader, from 30-50 in single cation mol% (40-59 wt%).

In another exemplary embodiment, the source material 34 composition includes a stabilizer that is an average single cation mol% of from 30-50%, for example 30-50% GdO_{1.5}.

The compositional range of gadolinia (Gd₂O₃) comprising an average of 40-50 in single cation mol% (50-59 wt%) relative to zirconia (ZrO2) has been shown to exhibit similar properties (intrinsic toughness, sintering resistance, thermal conductivity) to the 50 GdO_{1.5} - 50 ZrO₂ composition while minimizing the risk of layers of the coating exceeding a critical gadolinia content, at which the local compositional zone 50 could form that would be susceptible to accelerated degradation in engine service.

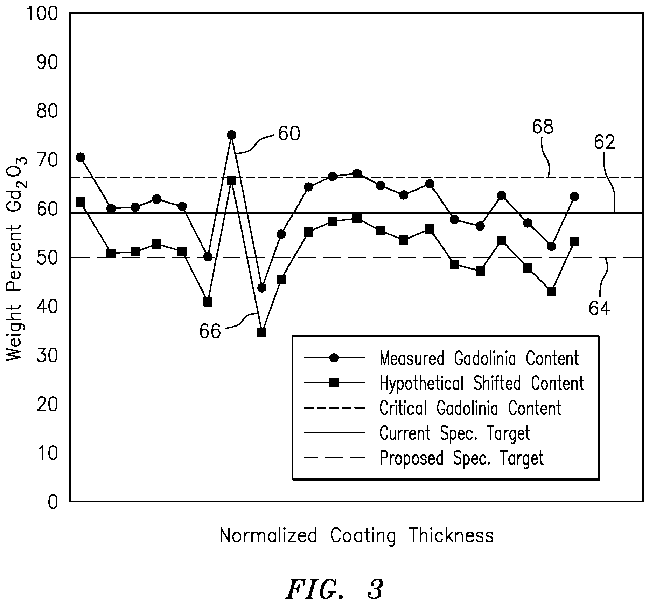

FIG. 3 illustrates a comparison of exemplary gadolinia content in a gadolinia-zirconia layer of a coating system. The plots at FIG. 3 show the measured gadolinia content 60 in the gadolinia zirconia layer of an exemplary coating utilizing a previously employed source material 34 in quantities of a currently specified target composition 62 compared with an improved source material 34 in quantities of the disclosed proposed specified target composition 64. The plot also shows a hypothetical reduction in target composition 66 compared to an expected coating content shift. The benefit of the disclosed solution is illustrated by the expected minimization of the gadolinia content excursions above the critical gadolinia content 68 threshold. Measurements in the field have discovered that gadolinia content with compositional fluctuations above 66 wt% gadolinia or a 57 single cation mol% (e.g., 57 mol% GdO_{1.5}) are susceptible to sulfur attack.

The disclosed process includes providing a source material 34, such as an ingot or suspension with particles, having a compositional range of gadolinium oxide (GdO_{1.5}) comprising an average of 30 to 50 single cation mole % (40-59 wt%) relative to zirconia (ZrO2). In another alternative embodiment, the compositional range of the source material can include a stabilizer from the group La, Nd, Pr, Sm, Eu, Gd, or combinations with a composition in single cation mol% of from 30-50 mol%. The ingot of source material 34 is placed into a crucible of an electron beam vapor deposition apparatus 10. At least one electron beam source 20, such as an electron gun, mounted relative to the coating chamber 14 is utilized for melting and evaporating the source coating material 34. The evaporated source material 34 is deposited onto the work piece 12 to form the coating system 40.

In another exemplary embodiment, a thermal spray process can be utilized and include a source material that enables the application of a coating with an improved compositional range. In the thermal spray process, the source material 34 particles can be more or less heated due to location within the flame of the torch. The amount of heating can result in individual particle composition changes. The result would be that individual deposited particles as splats that can have a range in compositions similar to that of the local compositional zone 50. The variation of the range in compositions can be controlled by use of the proper source material. The beneficial effect for the coating from thermal spray techniques would be the same as the local compositional zone that form in the EB-PVD examples provided herein.

A technical benefit of the disclosed process includes a reduced compositional target ingot which in turn can reduce the risk of sulfur attack of the thermal barrier coating and premature coating loss.

Another technical advantage of the disclosed process is minimization of gadolinia content excursions above the critical threshold and keeping the local compositional to that of below 66% Gd₂O₃ (57 single cation mol%) in the coating system.

Another technical advantage of the disclosed process is minimization of stabilizer content excursions above the critical threshold and keeping the local compositional to that of below the respective critical compositions for each of the stabilizers, La, Nd, Pr, Sm, Eu, Gd, and Tb or combinations thereof, in the coating system.

There has been provided a process. While the process has been described in the context of specific embodiments thereof, other unforeseen alternatives, modifications, and variations may become apparent to those skilled in the art having read the foregoing description. Accordingly, it is intended to embrace those alternatives, modifications, and variations which fall within the broad scope of the appended claims.

## Claims

1. A process for limiting a critical stabilizer content in coatings comprising:
placing a source coating material (34) in a crucible (32) of a vapor deposition apparatus (10) having a coating chamber (14), said source coating material (34) having compositional range of LnO_{1.5} comprising a single cation mol% of 30-50% relative to zirconia (ZrO₂), where Ln is selected from the group consisting of La, Pr, Nd, Sm, Eu, Gd, and Tb, and combinations thereof;
energizing said source coating material (34) with an electron beam that delivers a power density to the material (34) in the crucible (32) forming a vapor cloud from said source coating material (34); and
depositing said source coating material (34) as a coating system (40) onto a surface of a work piece (12).

2. The process according to claim 1, further comprising:
depositing at least one layer of the coating system (40) comprising phases of said source material (34) having a mixture of pyrochlore and zirconia-rich fluorite.

3. The process according to claim 1 or 2, further comprising:
preventing said coating system (40) from exceeding a critical stabilizer of Ln0_{1.5} content, where Ln = La, Pr, Nd, Sm, Eu and Tb, comprises an amount ranging from 52 to 56 mol% or greater, respectively; or
preventing said coating system (40) from exceeding a critical stabilizer content of GdO_{1.5} in an amount of 57 single cation mol% or greater.

4. The process according to any preceding claim, further comprising:
preventing formation of a local compositional zone (50) within the coating system (40) between an inner layer (48) and an outer layer (52) or within the outer layer (52), of a thermal barrier coating (48, 52) of the coating system (40), wherein the local compositional zone (50) to be prevented optionally comprises a stabilizer content in a band that exposes the coating system (40) to attack by sulfur and the formation of a stabilizer-containing sulfate phase.

5. A coating deposition system comprising:
a source material (34), said source material (34) having compositional range of a stabilizer comprising a single cation mol% range of 30-50 mol% relative to zirconia or hafnia;
an energy source (20) configured to energize said source material (34); and
a work piece (12) targeted by said deposition system (34); wherein said energy source (20) energizes said source material (34) to form a coating system (40) on said work piece (12).

6. The coating deposition system according to claim 5, wherein said coating system (40) comprises layers of a thermal barrier coating (48, 52), wherein said coating deposition system is optionally configured to prevent formation of a local compositional zone (50) within the layers of the thermal barrier coating (48, 52).

7. The coating deposition system according to claim 5 or 6, wherein said coating deposition system is configured to minimize the probability of the coating system (40) exceeding a critical stabilizer content, wherein said critical stabilizer content optionally comprises an amount of 52 mol% or greater.

8. The coating deposition system (40) according to any of claims 5 to 7, wherein said source material (34) comprises oxides in the form of Ln₂B₂O₇, where Ln is selected from the group consisting of La, Pr, Nd, Sm, Eu, Gd, and Tb; wherein B is selected from the group consisting of Zr and Hf.

9. A spallation resistant thermal barrier coating (40) formed by a process comprising:
providing a source material (34) having compositional range configured to shift a mean distribution of compositional fluctuations in the thermal barrier coating (40) resulting from said source material (34);
depositing said source coating material (34) onto a work piece (12); and
forming a coating system (40) comprising a thermal barrier coating (40).

10. The spallation resistant thermal barrier coating (40) formed by the process of claim 9, wherein said process further comprises:
placing said source material (34) in a crucible (32) of a vapor deposition apparatus (10) having a coating chamber (14), said source material (34) having a compositional range in single cation mol% of 30-50%; and
energizing said source material (34) with an electron beam that delivers a power density to the material in the crucible (32) forming a vapor cloud from said source coating material (34).

11. The spallation resistant thermal barrier coating (40) formed by the process of claim 9 or 10, wherein said process further comprises
forming a bond coat (44) on a surface of said work piece (12).

12. The spallation resistant thermal barrier coating (40) formed by the process of claim 11, wherein said coating system (40) further comprises:
an oxide layer (46) on top of said bond coat (44) opposite said surface of said work piece (12).

13. The spallation resistant thermal barrier coating (40) formed by the process of claim 12, wherein said thermal barrier coating (40) further comprises:
an inner layer (48) on said oxide layer (46) and an outer layer (52) on said inner layer (48) opposite said oxide layer (46) in the absence of a local compositional zone (50) in said thermal barrier coating (40), wherein said local compositional zone (50) optionally comprises a GdO_{1.5} content of 57 mol% or greater in a band within said coating system (40), wherein, further optionally the local compositional zone (50) comprises a gadolinia content in a band that exposes the coating system (40) to attack by sulfur and the formation of a gadolinium-containing sulfate phase.

14. The spallation resistant thermal barrier coating (40) formed by the process of any of claims 9 to 13 further comprising:
controlling stabilizers in the source material (34), said stabilizers selected from the group consisting of La, Pr, Nd, Sm, Eu, Gd, and Tb.

15. The spallation resistant thermal barrier coating (40) formed by the process of any of claims 9 to 14, the process further comprising:
placing said source material (34) comprising particles in a source container coupled to a thermal spray torch, said source material (34) having a compositional range in single cation mol% of 30-50%
propelling said source material (34) particles into said thermal spray torch;
heating said source material (34) particles within a flame of the thermal spray torch; and
forming multiple splats on the work piece (12), wherein the multiple splats include a compositional fluctuation below a threshold for stabilizer content of 52 to 57 single cation mol%, for cations La, Pr, Nd, Sm, Eu, Gd and Tb, respectively.
